# EUROPEAN PATENT APPLICATION

(11) **EP 4 779 343 A1**
(43) Date of publication of application: **22.07.2026**
(21) Application number: 25152896.4
(22) Date of filing: 20.01.2025
(51) Int. Cl.: G01R 33/38, G01R 33/3815

(54) **ACCELERATED COOLDOWN LOOP FOR LOW-CRYOGEN MAGNETIC RESONANCE IMAGING MAGNETS**

(71) Applicant: Koninklijke Philips N.V., 5656 AE Eindhoven (NL)
(72) Inventor: BROOMFIELD, Dylan, Eindhoven (NL)
(74) Representative: Philips Intellectual Property & Standards

(57) **Abstract**

A cooldown acceleration loop used to quickly cool down sealed magnetic resonance (MR) magnets. The cooldown acceleration loop is independent of the main cooling system inside the sealed magnet. In particular, a superconducting magnet system includes: a vacuum vessel; one or more shield coils; one or more one or more superconducting main coils, wherein the one or more shield coils and the one or more superconducting main coils are disposed within the vacuum vessel; a hermetically sealed cooling system disposed within the vacuum vessel and containing helium, the one or more shield coils and the one or more superconducting main coils being in thermal contact with the hermetically sealed cooling system; a cooldown acceleration loop comprising one or more fluid conduits disposed within the vacuum vessel and in thermal contact with at least the one or more shield coils and further comprising an inlet port and an outlet port at an exterior of the vacuum vessel; and a coldhead secured to a vacuum vessel and having its highest-stage cold station thermally connected to the hermetically sealed cooling system.

## Description

### FIELD OF THE INVENTION

The following relates generally to superconducting persistent magnets and, in particular, to a system and method for accelerating the cooldown time of magnetic resonance imaging (MRI) magnets that have a sealed cryostat, and related arts.

### BACKGROUND OF THE INVENTION

High field MRI magnets contain coils made of superconducting wire, which are required to maintain a cryogenic temperature to be operational. This temperature is usually maintained by a cryogenic cooler (e.g., a coldhead), which maintains the temperature of a large helium inventory. Maintaining this helium inventory at cryogenic temperature (e.g., around 4K or lower) over the extended deployment period of an MRI scanner can have a high financial burden for hospital sites around the world, which is a leading factor for development of cryogen-free magnets (sealed magnets). In general, these cryogen-free magnets contain a fraction of the original helium volume of a conventional system and such systems may be hermetically sealed, taking away the need to maintain the magnet with incorporation of additional helium. The following discloses certain improvements to facilitate ramping cryogen-free magnets to superconducting temperatures.

### SUMMARY OF THE INVENTION

One aspect of the present invention relates to a superconducting magnet system, including: a vacuum vessel; one or more superconducting coils disposed within the vacuum vessel; a hermetically sealed cooling system disposed within the vacuum vessel and containing helium, the one or more superconducting coils being in thermal contact with the hermetically sealed cooling system; a cooldown acceleration loop comprising one or more fluid conduits disposed within the vacuum vessel and in thermal contact with the one or more superconducting coils and further comprising an inlet port and an outlet port at an exterior of the vacuum vessel; and a coldhead secured to a vacuum vessel and having its highest-stage cold station thermally connected to the hermetically sealed cooling system.

Another aspect of the invention relates to a superconducting magnet system, including: a vacuum vessel; one or more shield coils; one or more superconducting main coils, wherein the one or more shield coils and the one or more superconducting main coils are disposed within the vacuum vessel; a hermetically sealed cooling system disposed within the vacuum vessel and containing helium, the one or more shield coils and the one or more superconducting main coils being in thermal contact with the hermetically sealed cooling system; a cooldown acceleration loop comprising one or more fluid conduits disposed within the vacuum vessel and in thermal contact with at least the one or more shield coils and further comprising an inlet port and an outlet port at an exterior of the vacuum vessel; and a coldhead secured to a vacuum vessel and having its highest-stage cold station thermally connected to the hermetically sealed cooling system.

### BRIEF DESCRIPTION OF THE DRAWINGS

The disclosure may take form in various components and arrangements of components, and in various steps and arrangements of steps. The drawings are only for purposes of illustrating the preferred embodiments and are not to be construed as limiting the disclosure.
Fig. 1 diagrammatically illustrates an exemplary embodiment of a magnetic resonance imaging (MRI) apparatus.
Fig. 2 illustrates an exemplary embodiment of a superconducting magnet system which may be employed in an MRI apparatus in accordance with aspects of the present invention.
Fig. 3 illustrates an exemplary embodiment of tubes suitable for use in accordance with the present invention.
Fig. 4 illustrates an exemplary embodiment of a superconducting magnet system which may be employed in an MRI apparatus in accordance with aspects of the present invention.
Fig. 5 shows a cross-sectional view of a magnet of the system of Fig. 2.
Fig. 6 illustrates an exemplary cooling circuit in accordance with aspects of the present invention.
Figs. 7A and 7B illustrate an exemplary embodiment in accordance with aspects of the present invention.
Fig. 8 shows exemplary flow chart operations of the system of Fig. 5.

### DETAILED DESCRIPTION OF EMBODIMENTS

Conventional MRI magnets use a vacuum jacketed liquid helium vessel, in which the superconducting windings are immersed in the liquid helium. A coldhead runs to keep the liquid helium at a cryogenic temperature effective to keep the superconducting windings in the superconducting state. Usually, the cryogenic temperature for superconductivity is around or below 4 degrees Kelvin (4K). This design requires a large quantity of helium that can be lost to evaporation over time, and places a large load on the coldhead.

In some newer generation designs (so-called "sealed magnet" or "helium-free" design), the superconducting magnet windings are disposed in a vacuum vessel and are in thermal contact with a hermetically sealed cooling circuit containing a much smaller volume of helium (e.g., less than 10 liters of helium when liquefied). A coldhead cools the closed (i.e., sealed) cooling circuit. The approach greatly reduces or eliminates helium loss, and the magnet can be ramped (e.g., warmed up and then cooled down) without incurring the cost of replacement helium.

One drawback of this newer generation design is increased cooldown time. The cooling circuit at room temperature contains gas helium at high pressure (e.g., 1000 psi) in order to accommodate the pressure decrease as the fixed quantity of helium in the sealed cooling circuit cools. This gas helium must be cooled down to below 4K or even lower (e.g. 3K) to achieve superconductivity of the superconducting windings, which takes a long time. By contrast, liquid helium is loaded directly into a conventional magnet helium vessel, which provides much faster cooldown albeit at the cost of a much larger helium inventory.

An improvement over the prior art is disclosed is now disclosed, wherein a sealed magnet is modified in that a fast cooldown loop (also referred to herein as a cooldown acceleration loop) is provided that is in thermal contact with (e.g. soldered to) the one or more coils (e.g., shield coils and/or main superconducting coils). In a modified cooldown sequence, upon startup of the coldhead a chilled or cryogenic fluid is flowed through the cooldown acceleration loop so as to achieve more rapid cooldown of the one or more main superconducting coils, wherein the cooldown acceleration loop is independent of the main cooling system inside the sealed magnet.

In some embodiments disclosed herein, getter material is disposed on portions of the external surface of the cooldown acceleration loop (that is, the surface exposed to the vacuum volume). Sealed magnets, while not consuming helium beyond the initial charge loaded into the sealed cooling circuit, do include a containing vacuum vessel in order to maintain a vacuum of around 10 -6 Torr or lower at room temperature. (The sealed cooling circuit and thermally connected superconducting windings will operate as a cryopump at magnet operating temperature so as to achieve pressures possibly as low as 10 -8 Torr or lower during operation). An advantage of sealed magnets is that they facilitate performing servicing, including warmup and subsequent cooldown of the magnet, onsite and possibly performed by hospital personnel. However, hospital personnel are often reluctant to deploy a mechanical pump in an MRI laboratory or other clinical setting due to concerns such as pump oil leakage, pump exhaust gases/particulates, or other environmental contamination. Hence, providing for more robust vacuum in the magnet cryostat by way of getter material disposed on the cooldown acceleration loop can facilitate on-site maintenance without the need for mechanical pumping of the vacuum volume.

The getter material, which can be carbon, activated carbon, or the like, is disposed inside the vacuum volume, and preferably on the external surface of the cooldown acceleration loop. For maximum effectiveness, this getter material should be cooled, and is of most importance early in the cooldown cycle when the vacuum vessel will be at highest pressure. In some embodiments, some or all of the getter material is disposed on the inlet pipe of the cooldown acceleration loop, which will be chilled fastest. In a variant embodiment, thermally conducting fins, panels, or the like may be attached to the cooldown acceleration loop, and even more preferably on the inlet pipe of the cooldown acceleration loop, to increase the surface area for the getter material.

One aspect of the present invention relates to flow passages (e.g., tubing, also referred to herein as the cooldown acceleration loop) that run along the one or more superconducting coils and/or the shield coils, but has openings at both ends to the outside world. In normal operation, these openings are closed, but when the magnet is ramping to superconducting temperatures, they are connected to an external supply of cryogen, which runs the cryogen cooling agent through the cooldown acceleration loop to accelerate the magnet's cool down time. All the cryogen used for this process can be captured, and after completing cool down of the magnet to superconducting temperatures, and the one or more ends of the cooldown acceleration loop are closed.

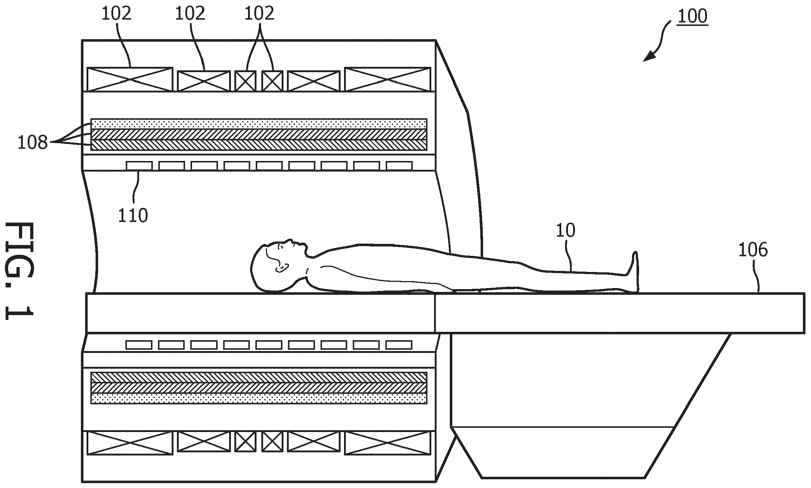

Fig. 1 illustrates one exemplary embodiment of a magnetic resonance imaging (MRI) apparatus 100. MRI apparatus 100 may include, for example, one or more superconducting windings 202 that form a superconducting magnet 104; a patient table 106 configured to hold a patient 10; gradient coils 108 configured to at least partially surround at least a portion of patient 10 for which MRI apparatus 100 generates an image; and a radio frequency coil 110 configured to apply a radio frequency signal to at least the portion of patient 10 that is being imaged, and to alter the alignment of this magnetic field; and a scanner (not shown) configured to detect changes in the magnetic field caused by the radio frequency signal. The general operation of an MRI apparatus is well known and therefore will not be repeated here.

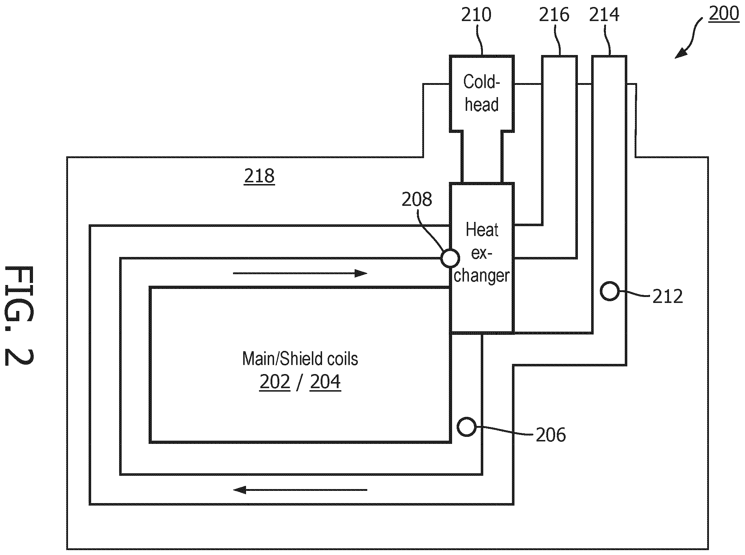

Referring Fig. 2, an exemplary system (i.e. sealed superconducting magnet) 200 in accordance with certain disclosed aspects is illustrated. The system 200 includes one or more superconducting main coils 202 and shield coils 204, confined within a sealed cooling system 206 that runs along one or more cooling panels of the superconducting main coils 202 and/or shield coils 204, and the mounting boards of other components to a heat exchanger 208 that is connected to a coldhead 210. The phrase "superconducting coil" without reference to "main" or "shield" should be interpreted as applying to one or more superconducting main coils 202 and shield coils 204. That is, both the one or more superconducting main coils 202 and the shield coils 204 are "superconducting coils".

The sealed cooling system 206 has a set amount of cryogenic cooling agent, such as helium. At operating temperature, this agent circulates through the system due to gravity induced convection. As disclosed herein, an additional set of high thermally conducting tubes form a fast cooldown loop 212 (also referred to herein as a cooldown acceleration loop 212 or a second cooling system) that makes intimate contact with at least one of the superconducting main coils 202 and/or shield coils 204, of the sealed cooling system 206. The cooldown acceleration loop 212 has at least one port 214, and more preferably two ports inlet port 214, and outlet port 216 that extend outside a cryostat 218. The cryostat 218 defines a vacuum volume, as illustrated in Fig. 2. The conducting tubes of the cooldown acceleration loop 212 itself can contain a gas or liquid at atmospheric pressure while the cryostat 218 remains at vacuum.

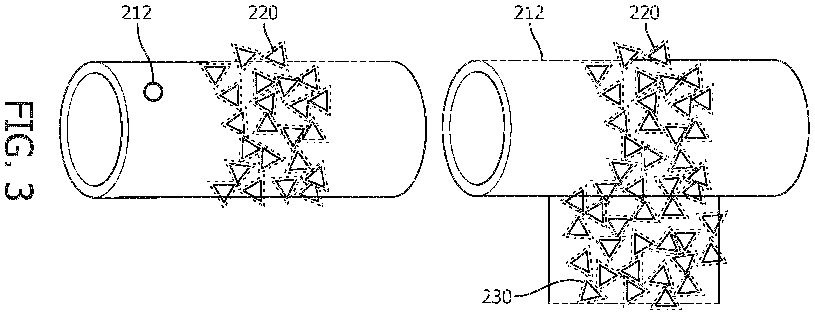

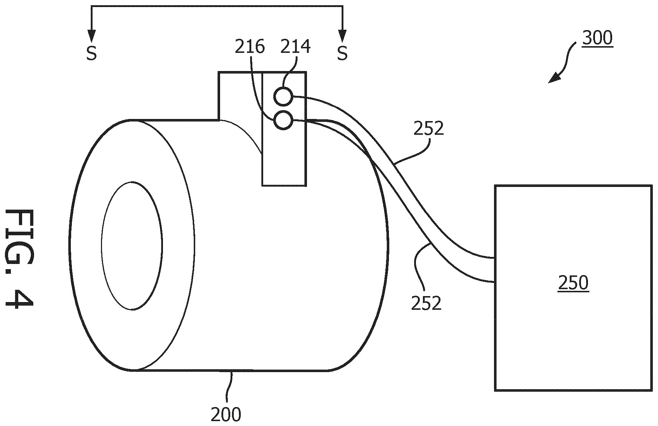

Referring to Fig. 3, getter material 220, such as charcoal or any other suitable material, is optionally mounted on the outer walls of the tubes of the cooldown acceleration loop 212, on the vacuum side (e.g., the portion of the cooldown acceleration loop inside the cryostat 218). The total surface area for the getter material can also optionally be increased by connecting high thermally conductive panels 230 on the cooldown acceleration loop 212, and mounting the getter material 220 on these panels 230. Referring to Fig. 4, an exemplary system 300 in accordance with certain disclosed aspects is illustrated and includes the sealed MRI magnet 200 of Fig. 2 and a cryostation with closed cryogen reservoir 250. The external ports 214, 216 of the cooldown acceleration loop 212 are closed off during normal operation of the magnet 200 to minimize heat input into the cryostat 218 through this system. For cooling down purposes, the external ports 214, 216 are connected to the external cryogenic plant 250 that runs a cryogen through the tubes 252, as illustrated in Fig. 4. Since the cooldown acceleration loop 212 is in contact with the one or more shield coils 204 and/or main coils 202 (see Fig. 2), it can take thermal energy out of the coils, and return it to the cooldown station, thereby assisting the magnet's coldhead 210 and accelerating cooldown of the magnet.

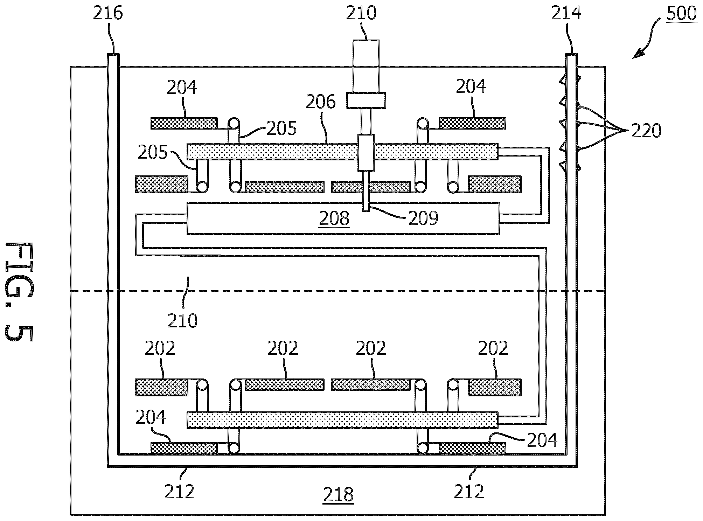

Fig. 5 illustrates cross-sectional view of a more specific embodiment of a sealed superconducting magnet 500 (which may, for example, correspond to a more detailed embodiment of the sealed superconducting magnet 200 of Fig. 3) shown as a longitudinal sectional view taken along Section S-S indicated in Fig. 4. The magnet 500 includes many components from the embodiment shown in Fig. 2, presented in greater detail in Fig. 5, and these analogous components are labeled with like reference numbers in Figs. 2 and 5. As shown in Fig. 5, the magnet 500 includes the cryostat (also referred to herein as a vacuum vessel) 218, which is evacuated during normal use, i.e. a vacuum vessel (and hence not filled with liquid helium). One or more superconducting main coils 202 (also referred to as magnetic windings 202) and shield coils 204 are disposed within the cryostat 218. The hermetically (i.e. airtight) sealed cooling system 206 that contains helium (either gas or liquid) is disposed in the vacuum vessel 218. In other words, the sealed cooling system 206 is initially charged with a helium charge, e.g. to around 1000 psi at atmospheric pressure in some non-limiting illustrative embodiments, and then sealed. The sealed cooling system 206 retains the helium charge in the sealed volume, and the sealed volume remains sealed thereafter during cooldown of the magnet and potentially also remains sealed over the course of repeated maintenance cycles in which the magnet is brought back to room temperature, serviced, and then cooled back down).

The one or more superconducting main coils 202 are in thermal contact with the sealed cooling system 206. In the illustrative arrangement, this is by way of tubes 205 of the sealed cooling system 204 (e.g., the lumens of the tubes 205 are part of the helium-containing sealed volume) that carry the helium charge to thermally conductive (e.g. metal) supports or formers around which the superconducting windings 202 are wound. The cooldown acceleration loop 212 includes one or more fluid conduits disposed in the vacuum vessel 214 and in thermal contact with the one or more superconducting main coils 202 and/or shield coils 204. The inlet port 214 and the outlet port 216 are disposed at an exterior of the vacuum vessel 218. The cold head 210 is secured to the vacuum vessel 218 and has a highest-stage cold station 209 (e.g., the second stage cold station of a two-stage cold head) that is thermally connected with the heat exchanger 208 that is in thermal contact with the sealed cooling system 206. The operating cold head 210 removes heat from the sealed cooling system 206.

As illustrated, the cooldown acceleration loop 212 is independent of the sealed cooling system 206. In one embodiment, the cooldown acceleration loop 212 is directly connected to the two shield coils 204 of the magnet. In this embodiment, the one or main coils 202 are not directly connected. Heat from the shield coils can now directly conduct into the cooldown acceleration loop 212. Heat transfer is no longer limited by the flow rate of the main sealed cooling, as it is in the prior art. The cooldown acceleration loop 212 uses an external pump 250 to force cryogenic fluid through it and therefore can achieve much higher flow rates and heat rejection than the sealed cooling system 206, for example. The one or more superconducting main coils 202 are then cooled indirectly through a combination of conduction through the structural components that hold the coils in place (e.g., the space frame (not shown)) and convection through the main sealed cooling system 206. Therefore, the main sealed cooling circuit 206 is still being used, but only has to remove heat from the one or more superconducting main coils 202. It is also in parallel with conduction through the structural components that hold the coils in place. Therefore, this approach can remove substantially more (e.g., more than twice) the heat of the approaches shown in the prior art.

With continuing reference to Fig. 5, and referring back to Fig. 3, getter material 220 previously described with reference to Fig. 3 is optionally disposed on an exterior of the inlet port 214 (and optionally also on the outlet port 216 although this is not shown in Fig. 5). In addition, the cooldown acceleration loop 212 can include the getter-coated high thermally conducting panels 230 of Fig. 3 (not shown in Fig. 5). The panels 230 can be configured as surface area-enhancing protrusions extending outwardly from an exterior of the inlet 214, outlet 216, or other piping of the cooldown acceleration loop. The getter material 220 can be disposed on these protrusions 230.

In some example embodiments, the magnet 500 exhibits different properties when in use (i.e. cooled down such that the one or more main superconducting main coils 202 are in the superconducting state and carrying a persistent superconducting current) and when not in use (i.e., when the one or more main superconducting main coils 202 are at room temperature). For example, in use, (i) the helium in the hermetically sealed cooling system 204 is at least partially liquefied; (ii) a vacuum inside the vacuum vessel 218 is at a pressure of 10⁻⁵ Torr or lower (which occurs because the cooling system 204 is at a cryogenic temperature, e.g. at or below 4K in some typical non-limiting embodiments, and therefore acts as a cryopump freezing out gasses in the vacuum vessel volume); (iii) the inlet port 214 and the outlet port 216 are sealed; (iv) a vacuum inside the cooldown acceleration loop 212 is at a pressure of 1 milliTorr or lower (and more typically at 10⁻⁵ torr or lower, but may be increase if there is a leak in the vacuum vessel 218); and (v) the vacuum inside the cooldown acceleration loop 212 is not in fluid communication with the vacuum inside the vacuum vessel 218. On the other hand, when the magnet is not in use (e.g., is at a sufficiently high temperature so that the one or more main superconducting main coils 202 are not in the superconducting state), then: (i) the helium in the hermetically sealed cooling system 204 is in the gas state and is at a gauge pressure of at least 100 psig, and more typically around 1000 psig when at room temperature; and (ii) the volume within the cooldown acceleration loop 212 is not in fluid communication with the volume of the vacuum vessel 214.

As shown in Fig. 2, the inlet port 214 and the outlet port 216 are disposed adjacent each other and on one side of the cold head 210. This same arrangement is shown in Fig. 4. Fig. 5 shows an alternative embodiment where the inlet port 214 and the outlet port 216 are disposed on opposing sides of the cold head 210 along the longitudinal direction. Advantageously, this arrangement allows for heat to dissipate from magnet 500 towards the outlet port 216 and away from the cold head 210, reducing the load on the cold head and allowing the cold head to cool the magnet more quickly.

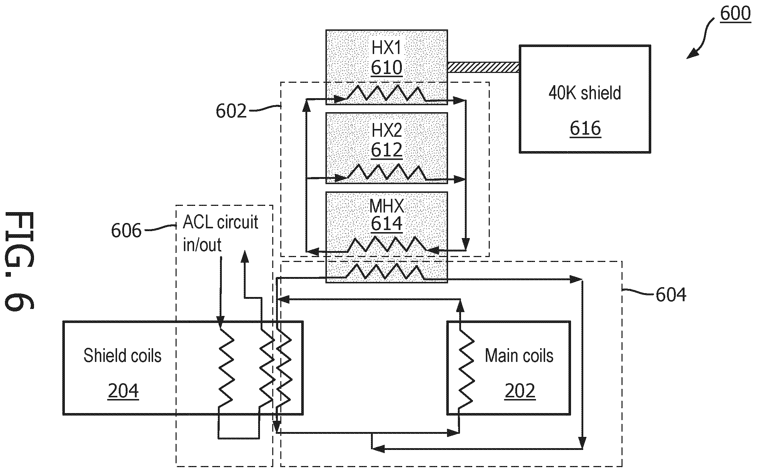

Referring to Fig.6, an exemplary cooling system 600 in accordance with aspects of the present invention is shown. There are three flow circuits in this figure--the main sealed cooling circuit 602, the main coil circuit 604, and the cooldown acceleration loop circuit 606. The primary sealed cooling circuit includes both the main sealed cooling circuit 602 and the main coil circuit 604. For example, the primary sealed cooling circuit includes the main sealed cooling circuit 602 is connected to heat exchanger (HX1) 610, heat exchanger (HX2) 612, and main heat exchanger (MHX) 614 and the main coil circuit 604 connected to the main heat exchanger (MHX) 614, the one or more main coils 202, and /or shield coils 204. Heat exchanger (HX1) 610 and heat exchanger (HX2) 612 are heat exchangers connected to the coldhead 210 that runs during normal operation. Heat exchanger (MHX) 614 is the main heat exchanger that exchanges heat from the main coil circuit 604 circuit to the main sealed cooling circuit 602. Heat exchanger (MHX) 614 may be needed because the circuits are operating at different pressures. In normal operation heat leaves the main sealed cooling circuit 602, goes into the main coil circuit 604, through the heat exchanger (MHX) 614, into the main sealed cooling circuit 602, and out heat exchanger (HX2) 612 and heat exchanger (HX1) 610, which is coupled to the 40K shield 616.

The cool down acceleration circuit 212 is an independent volume where external cryogenic fluid can be pumped through for cooldown. The shield coils 204 have a very good thermal connection to the primary sealed cooling circuit (circuits 602 & 604) so heat removal is only limited by power of the external pump 250. Furthermore, the main coil circuit 604 still thermally connects the shield coils 204 to the one or more main coils 202. When the cooldown acceleration loop is being used, the shield coils 204 will get colder than the one or more main coils 202 and then a thermosiphon will kick off. Therefore, heat from the one or more main coils 202 now goes through the main coil circuit 604, into the shield coils 204 and then out the cooldown acceleration loop 212. Like the prior art, aspects of this invention still use the main sealed cooling circuit for cooling. However, due to the coupling of the cooldown acceleration loop 212 to the shield coils 204 and/or the one or more main coils 202, the cooldown acceleration loop 212 can remove roughly twice the heat from the one or more main coils 202 because the main sealed cooling circuit does not have to also cool the shield coils 204. Furthermore, the structure of the magnet runs thermally in parallel with the main coil circuit so heat can also conduct from the one or more main coils 202 to the shield coils 204. Therefore, only a portion of the total heat has to transfer through the main sealed cooling circuit 602 and therefore the cooldown time is no longer limited by just the main sealed cooling circuit 602.

The cooldown acceleration loop 212 can be thermally connected to every coil (e.g., the one or main superconducting main coils 202 and/or shield coils 204) and therefore not use the main sealed cooling circuit 602 at all. While this would be the fastest cooldown approach, it would also require more expense (e.g., additional tubing and manufacturing time). In this embodiment, the cooldown acceleration circuit 212 is connected solely to the shield coils because it is a good trade-off of cost vs cooldown time.

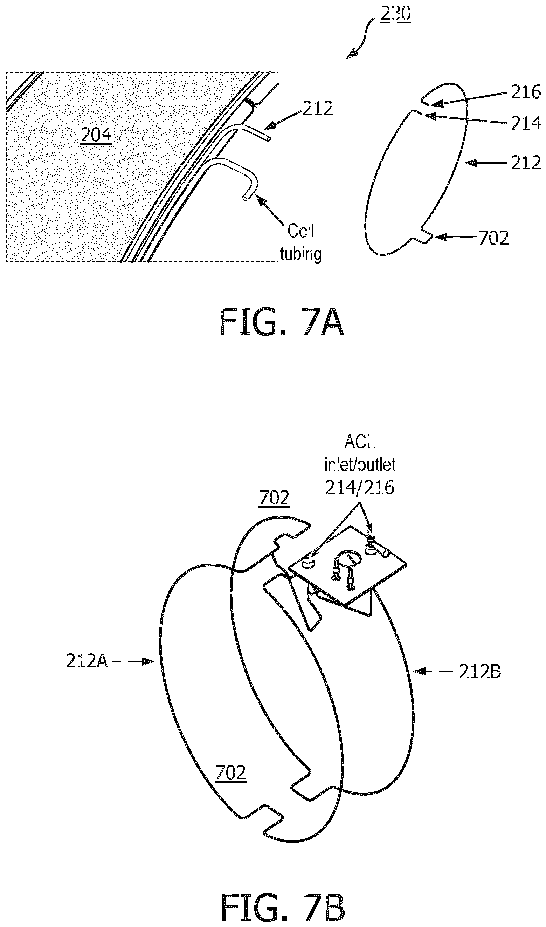

Referring to Figs. 7A and 7B, an exemplary cooldown acceleration loop 212 is shown. In Fig. 7A, a section of the shield coil 204 is shown. The cooldown acceleration loop 212 includes an inlet 214 and an outlet 214. The cooldown acceleration loop generally extends circumferentially around the shield coils 204 and/or one or more main superconducting main coils 202. As illustrated, thermally connected to the shield coil 204 is the tubing for the cooldown acceleration loop 212 and the tubing for the sealed cooling system 206. Tubing for both cooldown acceleration loop 212 and the tubing for the sealed cooling system 206 are in good thermal contact with the shield coil 204 so heat conducts into the cooldown acceleration loop 212 . Heat also conducts out of shield coil 204 and into the cooldown acceleration loop 212. Referring to Fig. 7B, an exemplary cooldown acceleration loop 212 for one embodiment is illustrated. There are two parallel paths (denoted 212A and 212B in Fig. 7B) in the cooldown acceleration loop 212, one per shield coil 204. In general, the tubes are copper tubes soldered directly to the cooling panel 230 of the shield coil 204. In one embodiment, at 0 and 180 degrees the connecting tubes may have one or more portions 702 that are stainless steel (or other desired material (e.g., a material having a higher electrical resistivity than copper) to prevent circulating circuits caused by the magnet Back-electromotive force (EMF) or other undesirable effects, for example. In one embodiment, the one or more portions 702 between the coils and the inlet/outlet ports 214/216 are manufactured from stainless steel, so as to prevent heat from conducting down through them to the one or more coils 202/204.

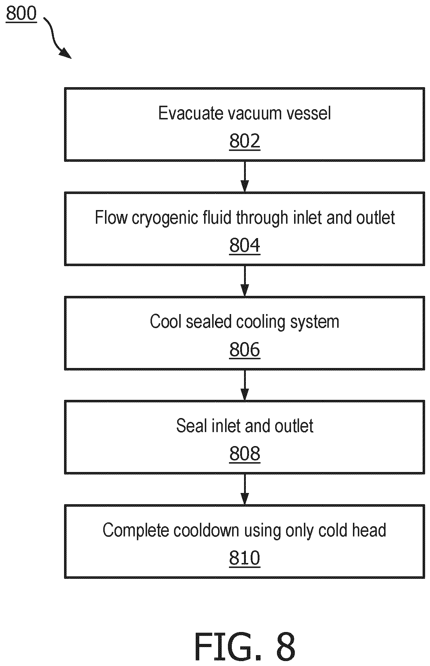

With reference to Fig. 8, an illustrative embodiment of an instance of a cooldown method 800 for cooling down the magnet 200 or 500 is diagrammatically shown as a flowchart. At 802, the vacuum vessel 218 is evacuated of fluid. At 804, a chilled or cryogenic fluid is flowed through the cooldown acceleration loop 212 via the inlet port 214 and the outlet port 216. At 806, which is performed concurrently with the flowing of the chilled or cryogenic fluid at 804, the sealed cooling system 206 is cooled by operation of the coldhead 210. At 808, the inlet port 214 and the outlet port 216 are sealed when the magnet 200/500 reaches a temperature at which the flow of chilled or cryogenic fluid through the cooldown acceleration loop 210 is no longer operating to accelerate the cooldown process or for any other reason. Depending upon the type of chilled or cryogenic fluid that is used, the step 808 may also include blowing out the cooldown acceleration loop 212 with nitrogen (e.g. if the chilled or cryogenic fluid is gas or liquid helium) and/or actively evacuating the cooldown acceleration loop 212 using a mechanical pump. At 810, the cooldown of the magnet 500 is thereafter completed using only the coldhead 210 to achieve a final temperature (e.g., 4K or lower in some non-limiting embodiments), at which the one or more main magnet windings 202 are in the superconducting state when carrying the design-basis persistent electrical current.

To perform the cooling operation 806, the coldhead 210 is operated to cool the cryogenic fluid disposed inside the sealed cooling system 206. The cooling operation 806 is accelerated by the concurrent operation 804 of flowing chilled or cryogenic fluid through the cooldown acceleration loop 212. The operation 808 at which the cooldown acceleration provided at 804 is terminated can be performed by evacuating the cryogenic fluid from the cooldown acceleration loop 212 when the superconducting magnet 200/500 falls below a predetermined temperature threshold. This can be performed in a variety of ways. In one example, the cryogenic fluid disposed inside the sealed cooling system 206 is gas helium at 80K. When the coldhead 210 is activated, the gas helium is evacuated when the magnet 200/500 falls below the predetermined temperature threshold (in this case, 80K). The gas helium is evacuated until the magnet reaches another predetermined temperature threshold; for example, 4K.

In another example, the gas helium can be evacuated when the magnet 200/500 reaches a temperature of approximately 20K. In this case, helium gas at a temperature of approximately 20K is flowed through the cooldown acceleration loop 212 through the inlet port 214 and the outlet port 216 until the magnet 200/500 reaches a temperature of approximately 4K.

In a further example, the cryogenic fluid is liquid nitrogen at a temperature of approximately 100K. The liquid nitrogen is evacuated when the magnet 200/500 reaches the point where the acceleration step 804 is no longer providing acceleration of the cooldown (in this case, at some temperature above 100K). The liquid nitrogen is then evacuated as part of operation 808 (e.g., by heating so that the liquid nitrogen evaporates) and cooldown continues at 810 via the coldhead 210 alone until the magnet reaches the final desired temperature for superconducting magnet operation.

In yet another example, the chilled or cryogenic fluid includes a combination of gas helium at approximately 80K, liquid nitrogen at a temperature of approximately 100K, and liquid helium. When the magnet 200/500 falls below a temperature at which the 100K helium gas provides cooldown acceleration, the gas helium is evaluated from the cooldown acceleration loop 212 (as described above), and the liquid nitrogen and liquid helium are heated for evaporation from the cooldown acceleration loop.

The disclosure has been described with reference to the preferred embodiments. Modifications and alterations may occur to others upon reading and understanding the preceding detailed description. It is intended that the exemplary embodiment be construed as including all such modifications and alterations insofar as they come within the scope of the appended claims or the equivalents thereof.

The illustrations of the embodiments described herein are intended to provide a general understanding of the structure of the various embodiments. The illustrations are not intended to serve as a complete description of all of the elements and features of the disclosure described herein. Many other embodiments may be apparent to those of skill in the art upon reviewing the disclosure. Other embodiments may be utilized and derived from the disclosure, such that structural and logical substitutions and changes may be made without departing from the scope of the disclosure. Additionally, the illustrations are merely representational and may not be drawn to scale. Certain proportions within the illustrations may be exaggerated, while other proportions may be minimized. Accordingly, the disclosure and the figures are to be regarded as illustrative rather than restrictive.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description. The Abstract of the Disclosure is provided to comply with 37 C.F.R. § 1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A superconducting magnet system, comprising:
a vacuum vessel;
one or more superconducting coils disposed within the vacuum vessel;
a hermetically sealed cooling system disposed within the vacuum vessel and containing helium, the one or more superconducting coils being in thermal contact with the hermetically sealed cooling system;
a cooldown acceleration loop comprising one or more fluid conduits disposed within the vacuum vessel and in thermal contact with the one or more superconducting coils and further comprising an inlet port and an outlet port at an exterior of the vacuum vessel;
a coldhead secured to a vacuum vessel and having its highest-stage cold station thermally connected to the hermetically sealed cooling system.

2. The system of claim 1, wherein heat transferred by the one or more coils is directly transferred into the cooldown acceleration loop.

3. The system of claim 2, where the one or more superconducting coils being directly cooled by the accelerated cooldown loop has heat transferred to it by the main hermetically sealed cooling system and at least one other coil has heat transferred out into the main hermetically sealed cooling system.

4. The system of claims 1, wherein the one or more superconducting coils is at least one shield coil.

5. The system of claim 4, wherein the at least one other coil is a main superconducting coil.

6. The system of any of claims 1-5, wherein the one or more superconducting coils is one or more main superconducting coils.

7. The system of claim 6, wherein the one or more main coils are cooled indirectly by a combination of convection through the cooldown acceleration loop and convection through the hermetically sealed cooling system.

8. The system of any of claims 1-7, wherein the hermetically sealed cooling system and the cooldown acceleration loop include separate stores of cryogenic material.

9. The system of any of claims 1-8, further including an external pump operatively coupled to the inlet and output ports to force cryogenic fluid though the cooldown acceleration loop.

10. The system of any of claims 1-9, wherein the cooldown acceleration loop is manufactured from a non-magnetic material.

11. The system of any of claims 1-9, wherein the cooldown acceleration loop includes a portion manufactured from a copper material and one or more sections manufactured from a material having a higher electrical resistivity than the copper material.

12. A superconducting magnet system, comprising:
a vacuum vessel;
one or more shield coils;
one or more one or more superconducting main coils, wherein the one or more shield coils and the one or more superconducting main coils are disposed within the vacuum vessel;
a hermetically sealed cooling system disposed within the vacuum vessel and containing helium, the one or more shield coils and the one or more superconducting main coils being in thermal contact with the hermetically sealed cooling system;
a cooldown acceleration loop comprising one or more fluid conduits disposed within the vacuum vessel and in thermal contact with at least the one or more shield coils and further comprising an inlet port and an outlet port at an exterior of the vacuum vessel;
a coldhead secured to a vacuum vessel and having its highest-stage cold station thermally connected to the hermetically sealed cooling system.

13. The system of claim 12, wherein heat transferred by the one or more shield coils is directly transferred into the cooldown acceleration loop.

14. The system of claim 13, wherein the at least one or more superconducting main coils has heat transferred out into the main hermetically sealed cooling system.

15. The system of claim 13, wherein the one or more main superconducting coils are cooled indirectly by a combination of convection through the cooldown acceleration loop and convection through the hermetically sealed cooling system.
